# EUROPÄISCHE PATENTSCHRIFT

(11) **EP 0 429 850 B1**
(45) Veröffentlichungstag und Bekanntmachung des Hinweises auf die Patenterteilung: **16.08.1995**
(21) Anmeldenummer: 90120323.2
(22) Anmeldetag: 23.10.1990
(51) Int. Cl.: H03K 3/033, H03K 5/01

(54) **Schaltungsanordnung zur Taktregenerierung in taktgesteuerten Informationsverarbeitungsanlagen**
Clock regeneration circuit for a clocked information processing system
Circuit de régénération d'horloge pour installation de traitement de l'information commandée par une horloge

(30) Priorität: 29.11.1989 DE 3939457
(43) Veröffentlichungstag der Anmeldung: 05.06.1991
(73) Patentinhaber: SIEMENS AKTIENGESELLSCHAFT, 80333 München (DE)
(72) Erfinder: Nagler, Werner, Dipl.-Ing., 82069 Schäftlarn (DE); Schmidt, Lothar, Ing., 82256 Fürstenfeldbruck (DE)

(56) Entgegenhaltungen:
- EDN, Band 34, Nr. 13, 22. Juni 1989, Seite 234; J. HONEA: "Single shots reside in PLDs"
- J. Markus , " Modern Electronic Circuits Reference Manual ", McGraw-Hill Book Company, 1980, Seite 620, Schaltung "PULSE-TRIGGERED MONO"; Seite 255, Schaltung "EXCLUSIVE-OR GATES"

## Beschreibung

Durch die Patentschriften DE 32 27 848 C2 und DE 32 27 849 C2 sind Schaltungsanordnungen auf der Basis spannungsgesteuerter Oszillatoren bekannt, die zur Taktregenerierung verwendbar sind. Es ergeben sich jedoch zum Beispiel im Zusammenhang mit taktgesteuerten Vermittlungsanlagen sehr oft Probleme, die mit den bekannten Schaltungsanordnungen nicht mehr bewältigt werden können. Bei Informationsverarbeitungsanlagen spielt die Bereitstellung von Übertragungswegen für einen unterbrechungsfreien Nachrichtenfluß eine überragende Rolle. Zu diesem Zweck werden die Nachrichtenwege gedoppelt parallel ausgelegt. Die Realisierung dieser Parallelwege erfolgt also durch Doppelung von Einrichtungen. Die in der Doppelung liegende Sicherheit läßt sich dadurch realisieren, daß im Störungsfall jeweils auf den Parallelweg umgeschaltet wird. Ein solcher Störungsfall ist immer dann gegeben, wenn der Nachrichtenfluß bzw. der ihm zugeordnete Bitstrom irgendwie beeinträchtigt oder sogar unterbrochen wird. Dies löst eine Umschaltung bzw. Umlenkung, nämlich auf den jeweiligen Ersatzweg aus. Dabei kann es aber zu einer zusätzlichen Störung immer dann kommen, wenn der Gleichlauf zwischen den beiden Bitströmen nicht gegeben ist. Der Gleichlauf kann durch Verzerrungen des steuernden Taktes z.B. in Frequenz und/oder Phase beeinträchtigt werden.

Um die Verzerrungsprobleme zu beheben, ist die Bereitstellung eines in Phase und Frequenz einheitlichen, hochgradig übereinstimmenden Taktrasters erforderlich. Ein solches einheitliches, hochgradig übereinstimmendes Taktraster wird auf der Basis eines zentralen Taktes gewonnen (siehe deutsche Patentschrift 3111022), wobei aber dieser zentrale Takt aufgrund Laufzeit- und/oder Bauteiletoleranzen derart verzerrt sein kann, daß er nicht mehr unmittelbar die an ihn gestellten Bedingungen erfüllt und deshalb halb nicht mehr unmittelbar verwendet werden kann.

Aus diesem Grunde sind Schaltungsanordnungen zur Taktregenerierung erforderlich. Taktregenerierungseinrichtungen auf der Basis spannungsgesteuerter Oszillatoren, wie sie in obigen Patentschriften beschrieben sind, besitzen aber folgende Nachteile:
1.) Der Gleichlauf bezüglich Frequenz und Phasenlage zwischen Synchronisiertakt und dem mittels der oben erwähnten Schaltungsanordnungen auf der Basis spanngesteuerter Oszillatoren regenerierten Takt kann nicht garantiert werden, wie praktische Erfahrungen gezeigt haben. Damit ist die für die Aufsynchronisierung von Signalen bezüglich Frequenz und Phasenlage notwendige Phasenbeziehung nicht erfüllt.
2.) Einzelne Störeinkopplungen - zum Beispiel kann es durch Blitzeinwirkung auf der Teilnehmerleitung zu Einkopplungen in Form von Nadelimpulsen kommen - führen wegen des Nachziehverhaltens der Rückkoppeleinrichtung zu länger andauernden Frequenz- und Phasenlageabweichungen und - damit einhergehend - zu einer Verfälschung der zu übertragenden Information.

Aus der Druckschrift 'Modern Electronic Circuits Reference Manual, John Marcus, McGrawhill Book Company, 1980, Seite 620, Schaltung PULS-TRIGGERED MONO' ist eine Taktregeneriereinrichtung bekannt. Bei einer derartigen Vorrichtung besteht jedoch das Problem, daß ein externer Takt, der eine sehr viel höhere Frequenz aufweisen muß, als der zu regenerierende Takt vorzusehen ist. Derartige Lösungsansätze sind somit überall dort nicht verwendbar, wo ein externer Takt nicht zur Verfügung steht oder nur mit hohem Aufwand bereitgestellt werden kann.

Der Erfindung liegt also die Aufgabe zugrunde, eine Taktregenerierungsschaltung anzugeben, die
1.) eine Phasensynchronität zwischen Eingangs- und Ausgangssignal garantiert,
2.) länger andauernde Frequenzabweichungen aufgrund einzelner Störeinkopplungen z.B. in Form von Nadelimpulsen vermeidet.

Die Lösung dieser Aufgabe ergibt sich aus Patentanspruch 1. Vorteilhafte Weiterbildugnen und Ausgestaltungen der Erfindung sind in den Unteransprüchen angegeben. Im Anspruch 7 ist die vorteilhafte Anwendung der erfindungsgemäßen Schaltungsanordnung auf eine taktgesteuerte Fernsprechanlage angegeben. Hier ermöglicht die erfindungsgemäße Schaltungsanordnung die Rückgewinnung eines einheitlichen Taktrasters, das den Weg eröffnet, in einer solchen Fernmeldeanlage den für die Übertragung der Signalisierungsinformation vorgesehenen Nachrichtenkanal unabhängig von dem jeweiligen Datenweg in Richtung zu einem Koppelnetz der Anlage durchzuschalten.

Im folgenden sei die Erfindung anhand einer Zeichnung näher erläutert:
- FIG 1: zeigt einen Ausschnitt aus einer Fernmeldeanlage, in der die erfindungsgemäße Schaltungsanordnung verwendet wird.

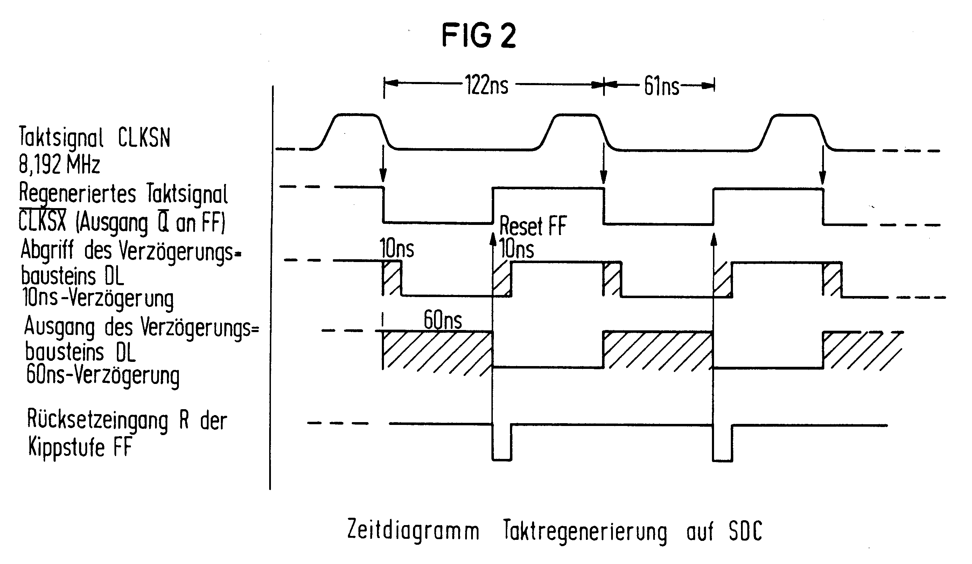

- FIG 2: zeigt ein Zeitdiagramm zur Erläuterung der Erfindung.

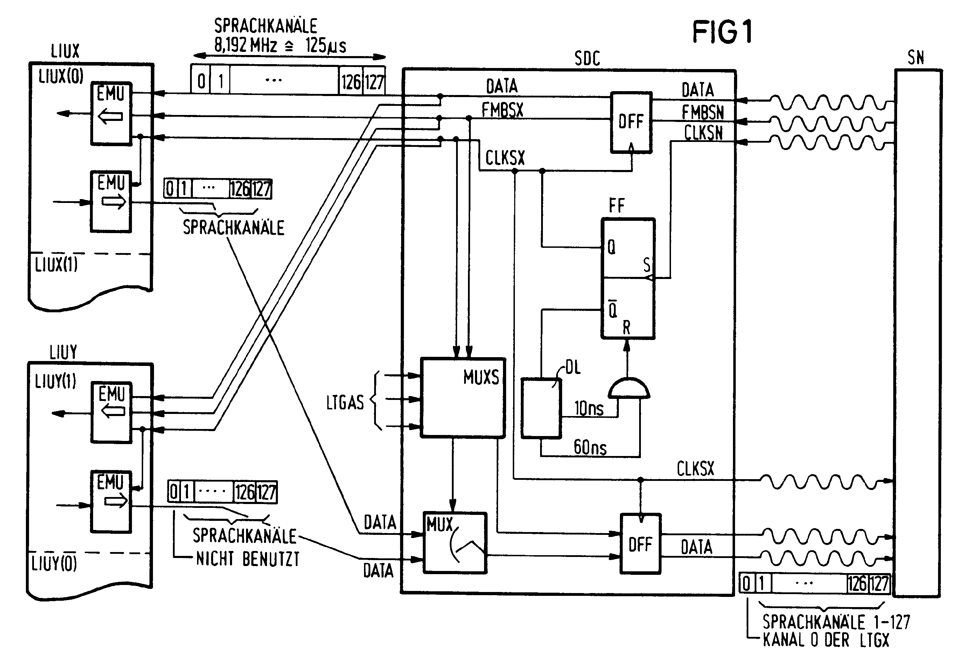

Das in FIG 1 dargestellte Ausführungsbeispiel baut auf einer Darstellung und Beschreibung einer PCM-Fernsprechvermittlungsanlage auf, wie sie in beispielsweise der europäischen Patentanmeldung 0 236 779 beschrieben ist. Die Beschreibung des erfindungsgemäßen Ausführungsbeispiels geht also davon aus, daß eine zentralgesteuerte PCM Fernsprechvermittlungsanlage von der Art bekannt ist, wie sie in der zuvor erwähnten europäischen Patentanmeldung dargestellt und erläutert ist. Darüber hinaus ist durch die deutsche Patentanmeldung P 3832242.0 eine Vermittlungsanlage mit paarweise einander zugeordneten ("redundanten") Anschlußgruppen bekannt, die an ein gedoppeltes Koppelnetz angeschlossen sind. Dort ist auch die Bedeutung eines einheitlichen Taktrasters für die Funktion der Anlage beschrieben.

Das in FIG 1 dargestellte erfindungsgemäße Ausführungsbeispiel baut auf der Darstellung und Beschreibung des Anschlusses der jeweils einzeln paarweise einander zugeordneten Anschlußgruppen LTGX (LTGX(0), LTGX(1)) und LTGY, (LTGY(0), LTGY(1)) an das gedoppelte Koppelfeld SN (SN0, SN1) auf, und stellt damit einen Ausschnitt des in obiger Patentanmeldung (P 3832242.0) gezeigten Ausführungsbeispiels dar. Es ist davon abgesehen worden, im vorliegenden Rahmen eine solche Anlage erneut zu beschreiben.

Die in FIG 1 abgebildeten Einrichtungen zeigen ein Koppelfeld SN, eine Taktregenerierungsbaugruppe, sowie zwei Linkanschlußschaltungen LIUX und LIUY. Letztere enthalten Ausgleichsspeicher EMU. Solche Ausgleichsspeicher sind vielfältig bekannt (siehe oben) Sie sind immer da vorzusehen, wo Impulsfolgen aufzunehmen sind, deren Takt mit demjenigen in Einklang zu bringen ist, der innerhalb der betreffenden Baueinheit jeweils maßgebend ist. Damit wird eine Einsynchronisierung bezüglich Frequenz und Phase der zu übertragenden, also jeweils aufzunehmenden Impulse der aufzunehmenden Impulsfolge erreicht.

Wie bereits oben erwähnt, werden in Informationsverarbeitungsanlagen aus Sicherheitsgründen viele Einrichtungen gedoppelt. In FIG 1 sind dies z. B. Linkanschlußschaltungen LIUX und LIUY. Sie stellen die Schnittstelle zu den - nicht im obigen Anwendungsbeispiel näher erläuterten - Anschlußgruppen LTG dar (siehe Patentanmeldung P3832242.0). Damit stehen den Informationsdaten, die in FIG 1 mit "Data" bezeichnet sind, zwei völlig identische Wege zur Verfügung. Wie ebenfalls bereits oben erwähnt wurde, erfolgt im Störungsfall eine Umschaltung bzw. Umlenkung auf den jeweiligen Ersatzweg. Beide Wege laufen an einem sogenannten Übergabepunkt wieder zu einem Weg zusammen, der zum Koppelfeld SN hin weiterverläuft. Ein solcher Übergabepunkt ist im obigen Anwendungsbeispiel durch einen Multiplexer MUX realisiert. Seine Aufgabe besteht neben seiner an sich bekannten Multiplexerfunktionen im hiergegebenen Zusammenhang:
1) im alternativen Empfangen von Bitstrom 1 oder 2 und dem jeweiligen Weiterschalten in Richtung Koppelfeld SN,
2) dafür Sorge zu tragen, daß immer nur der die Signalisierungsinformation tragende Nachrichtenkanal - das ist in obigem Anwendungsbeispiel der Nachrichtenkanal 0̸ nur der LIUX - mit den Sprachkanälen 1-127 der LIUX oder LIUY zusammengeschaltet und der daraus resultierende Rahmen in Richtung Koppelfeld SN weitergeschaltet wird. Dies bedeutet im Normalbetrieb, daß der Multiplexer den die Signalisierungsinformation tragenden Nachrichtenkanal 0 der LIUX zusammen mit den Sprachkanälen 1-127 der LIUX als kompletten Rahmen in Richtung Koppelfeld SN weiterschaltet.
   Im Umschaltbetrieb hingegegen schaltet der Multiplexer MUX den die Signalisierungsinformation tragenden Nachrichtenkanal 0 der LIUX mit den Sprachkanälen der LIUY zusammen und schaltet diesen dadurch entstandenen Rahmen in Richtung Koppelfeld weiter.

Die Lösung dieser Aufgabe kann aber nur dann gelingen, wenn die Informationsdaten Data beider Wege takt-, phasen- und rahmensynchron an den Endpunkten beider Wege, die durch die Ausgleichsspeicher EMU repräsentiert, also am Eingang des Multiplexers MUX zum zeitlichen Übereinanderliegen gebracht werden. Dies geschieht beim Auslesen der Informationsdaten Data aus jedem der beiden Ausgleichsspeicher mit gleichem Takt und gleicher Rahmenkennung. Diese Informationsdaten gelangen also von 2 Ausgleichsspeichern EMU zu den Multiplexern MUX, und diese verwenden Informationsdaten und Signalisierungsdaten in der bereits angegebenen Weise.

Es besteht also die Notwendigkeit, die Impulsfolgen für Takt-, Rahmenkennung-und Informationsdaten zeitlich zum Übereinanderliegen zu bringen und an beide Ausgleichsspeicher EMU weiterzuleiten. Als Basistakt wird der vom Koppelnetz ankommende Systemtakt CLSN verwendet.

FIG 1 zeigt die vom Koppelnetz SN0 ankommenden Signale Data, FMBSN,CLKSN. Diese Signale sind aufgrund der langen Wegezuführung (bis zu 250 m) sowie aufgrund von Bauteiletoleranzen verzerrt und müssen in Frequenz, Pegel und Phase regeneriert werden. Insbesondere fehlt hinsichtlich der relativen Phasenbeziehung der drei Signale die Takt-, Phasen-, und Rahmenübereinstimmung; diese muß wieder hergestellt werden. Die Aufgabe wird erfindungsgemäß u.a. dadurch gelöst, daß das Taktsignal CLKSN auf den Setzeingang S einer Flip-Flop-Schaltung FF gegeben wird. Das ausgangsseitige Signal Q̅ der Flip-Flop-Schaltung FF, das über einen zweiten zum ersten Ausgang Q inversen Ausgang gewonnen wird, wobei auch alternativ eine Lösung mittels einem im Ausgang Q nachgeschalteten Inversionsglied denkbar ist, wird auf einen Verzögerungsbaustein (Delay Line DL) gegeben. Dieser besitzt zwei Ausgänge und zwar mit 10 Nanosekunden sowie 60 Nanosekunden Verzögerungszeit. Die beiden mit diesen Verzögerungszeiten gekennzeichneten Ausgangssignale des Verzögerungsbausteins (Delay Line DL) sind an ein UND-Gatter angeschlossen, das seinerseits ausgangsseitig mit dem Rücksetzeingang R der Flip-Flop-Schaltung FF verbunden ist. Diese Verzögerungszeit von 10 Nanosekunden dient dazu, ein stabiles Anstehen des Rücksetzsignals am Rücksetzeingang R sicherzustellen und damit ein sicheres Rücksetzen der Flip-Flop-Schaltung FF zu gewährleisten.

Die oben beschriebene erfindungsgemäße Schaltungsanordnung stellt also sowohl die Einheitlichkeit in Frequenz und Phase wieder her, als daß Sie auch die Gefahr, daß einzelne Störeinkopplungen in Form von Nadelimpulsen zu länger andauernden Frequenzabweichungen führen, eliminiert. Diese Vorteile konnten mit den Verfahren, wie sie weiter oben erwähnt wurden, nicht erzielt werden, weil
1. praktische Erfahrungen gezeigt haben, daß eine feste Phasenbeziehung zwischen Ausgangs- und Eingangssignal nicht garantiert werden kann,
2. Störeinkopplungen in Form von Nadelimpulsen aufgrund des Nachziehverhaltens der Rückkoppeleinrichtung unweigerlich zu Frequenzabweichungen führen.

Diese beiden Sachverhalte sind zwar auf vielen Anwendungsgebieten der Technik unproblematisch dar; aber überall dort, wo auf ein einheitliches Taktraster mit den Eigenschaften, wie sie weiter oben beschrieben sind, zurückgegriffen werden muß, weist eine Taktregenerierung mittels der erfindungsgemäßen Schaltungsanordnung bisher nicht erzielte Vorteile auf. Damit ist es nun gelungen, Informationsverluste bei Umschaltevorgängen zu vermeiden.

## Patentansprüche

1. Schaltungsanordnung zur Taktregenerierung in taktgesteuerten Informationsverarbeitungsanlagen,
**dadurch gekennzeichnet,**
daß der zu regenerierende Takt auf den Eingang einer Flip-Flop-Schaltung gegeben wird und
daß ein zum Ausgangssignal dieser Flip-Flop-Schaltung inverses Signal über eine Verzögerungsleitung, deren Verzögerungszeit kürzer ist als die Taktperiode des zu regenerierenden Taktes, auf den Rücksetzeingang der Flip-Flop-Schaltung rückgekoppelt wird.

2. Schaltungsanordnung nach Anspruch 1,
**dadurch gekennzeichnet,**
daß das inverse Ausgangssignal über ein dem Ausgang der Flip-Flop-Schaltung nachgeschaltetes Inversionsglied gewonnen wird.

3. Schaltungsanordnung nach Anspruch 1 oder 2,
**dadurch gekennzeichnet,**
daß das inverse Ausgangssignal über einen zweiten zum ersten Ausgang der Flip-Flop-Schaltung inversen Ausgang gewonnen wird.

4. Schaltungsanordnung nach einem der Ansprüche 1 bis 3,
**dadurch gekennzeichnet,**
daß die Verzögerungszeit dem gewünschten Tastverhältnis des zu regenerierenden Taktes entspricht.

5. Schaltungsanordnung nach einem der Ansprüche 1 bis 4,
**dadurch gekennzeichnet,**
daß die Verzögerungszeit der Verzögerungseinrichtung der halben Periodendauer des zu regenerierenden Taktsignals entspricht.

6. Schaltungsanordnung nach einem der vorhergehenden Ansprüche,
**dadurch gekennzeichnet,**
daß die in den Rückkoppelzweig eingefügte Verzögerungseinrichtung zwei unterschiedlichen Verzögerungszeiten entsprechende Ausgänge besitzt, deren Signale auf eine Verknüpfungsschaltung gegeben werden, die ausgangsseitig mit dem Rücksetzeingang der Flip-Flop-Schaltung verbunden ist, und
daß die kürzere der beiden Verzögerungszeiten so bemessen ist, daß ein sicheres Rücksetzen der Flip-Flop-Schaltung gewährleistet ist.

7. Schaltungsanordnung nach einem der vorhergehenden Ansprüche,
**gekennzeichnet,**
durch die Verwendung in einer taktgesteuerten Fernmeldeanlage, insbesondere zentralgesteuerten Fernsprechvermittlungsanlagen, in denen aus Sicherheitsgründen gedoppelte Datenwege vorgesehen sind, und deren Ende zum Ausgleich unterschiedlicher Laufzeiten Ausgleichsspeicher lokalisiert sind, damit im Fehlerfall stets ein Ersatzweg zum Datentransport zur Verfügung steht, und in denen Umschaltevorrichtungen zum Umschalten zwischen den gedoppelten Datenwegen vorgesehen sind, mit der Verwendung eines an den Ausgleichsspeichern anliegenden in Phase und Frequenz einheitlichen Taktrasters, das basierend auf den akommenden, durch Laufzeit und Bauteiletoleranzen verzerrten Taktes auf einer zentralen Einrichtung regeneriert wird.

8. Schaltungsanordnung nach Anspruch 7,
**dadurch gekennzeichnet,**
daß das regenerierte Taktsignal nicht nur an die Ausgleichsspeicher angelegt ist, sondern auch an eine den Ausgleichsspeichern vorgeschaltete Synchronisiereinrichtung, mit deren Hilfe von einem Koppelfeld ankommende Signale mit dem regenerierten Taktsignal zum zeitlichen Übereinanderliegen gebracht werden, weitergeleitet wird.

9. Schaltungsanordnung nach Anspruch 7,
**dadurch gekennzeichnet,**
daß unter Verwendung des eine Phase und Frequenz regenerierten, einheitlichen Taktrasters der für die Übertragung der Signalisierungsinformation vorgesehene Nachrichtenkanal in Richtung zu einem Koppelnetz der Anlage unabhängig von dem gewählten Datenweg durchgeschaltet wird.

## Claims

1. Circuit arrangement for clock regeneration in clock-controlled information processing systems, characterized in that the clock to be regenerated is sent to the input of a flip-flop circuit, and in that a signal inverse to the output signal of this flip-flop circuit is fed back via a delay line, whose delay time is shorter than the clock period of the clock to be regenerated, to the reset input of the flip-flop circuit.

2. Circuit arrangement according to Claim 1, characterized in that the inverse output signal is obtained via an inverting element connected downstream of the output of the flip-flop circuit.

3. Circuit arrangement according to Claim 1 or 2, characterized in that the inverse output signal is obtained by a second output inverse to the first output of the flip-flop circuit.

4. Circuit arrangement according to one of Claims 1 to 3, characterized in that the delay time corresponds to the desired pulse duty factor of the clock to be regenerated.

5. Circuit arrangement according to one of Claims 1 to 4, characterized in that the delay time of the delay device corresponds to half the period of the clock signal to be regenerated.

6. Circuit arrangement according to one of the preceding claims, characterized in that the delay device inserted into the feed back branch has two outputs corresponding to different delay times and whose signals are sent to the logic circuit which is connected on the output side to the reset input of the flip-flop circuit, and in that the shorter of the two delay times is dimensioned such that reliable resetting of the flip-flop circuit is ensured.

7. Circuit arrangement according to one of the preceding claims, characterized by the use in a clock-controlled information processing system, in particular centrally controlled telephone switching systems in which data paths are provided for reliability reasons and at whose ends compensating memories are located for compensating different transit times so that an alternate route is always present for data transfer in case of a fault, and in which systems switchover devices are provided for switching over between the dual data paths, accompanied by the use of a clock grid which is connected to the compensating memories, is uniform in phase and frequency and is regenerated on a central device on the basis of the incoming clock, which is distorted by the transit time and component tolerances.

8. Circuit arrangement according to Claim 7, characterized in that the regenerated clock signal is not only applied to the compensating memories, but is also routed to a synchronizing device which is connected upstream of the compensating memories and with the aid of which signals incoming from a switching network are brought into temporal superimposition with the regenerated clock signal.

9. Circuit arrangement according to Claim 7, characterized in that with the use of the uniform clock grid regenerated in phase and frequency the transmission channel provided for transmitting the signalling information is switched through in the direction of a switching network of the system independently of the selected data path.

## Revendications

1. Montage regénérateur de cadence dans des installations de traitement d'informations commandées de façon cadencée, caractérisé par le fait
que la cadence devant être régénérée est appliquée à l'entrée d'un circuit à bascule bistable, et
qu'un signal inverse du signal de sortie de ce circuit à bascule bistable est renvoyé par réaction à l'entrée de remise à l'état initial du circuit à bascule bistable par l'intermédiaire d'une ligne à retard, dont le temps de retard est inférieur à la période de la cadence devant être régénérée.

2. Montage suivant la revendication 1, caractérisé par le fait que le signal de sortie inverse est obtenu par l'intermédiaire d'un circuit inverseur branché en aval de la sortie du circuit à bascule bistable.

3. Montage suivant la revendication 1 ou 2, caractérisé par le fait que le signal de sortie inverse est obtenu par l'intermédiaire d'une seconde sortie inverse de la première sortie du circuit à bascule bistable.

4. Montage suivant l'une des revendications 1 à 3, caractérisé par le fait que le retard correspond au taux d'impulsions désiré de la cadence devant être régénérée.

5. Montage suivant l'une des revendications 1 à 4, caractérisé par le fait que le retard produit par le dispositif de retardement correspond à la moitié de la période du signal de cadence devant être régénéré.

6. Montage suivant l'une des revendications précédentes, caractérisé par le fait que
le dispositif de retardement inséré dans la branche de réaction possède deux sorties, qui correspondent à des retards différents et dont les signaux sont envoyés à un circuit combinatoire qui est relié, côté sortie, à l'entrée de remise à l'état initial du circuit à bascule bistable, et
que le plus court des deux retards est dimensionné de manière à garantir une remise à l'état initial sûre du circuit à bascule bistable.

7. Montage suivant l'une des revendications précédentes, caractérisé par son utilisation dans une installation de télécommunication commandée de façon cadencée, notamment dans des installations de commutation téléphonique à commande centrale, dans lesquelles sont prévues des voies de transmission de données, doublées pour des questions de sécurité, et à l'extrémité desquelles sont disposées des mémoires de compensation servant à compenser des temps de transit différents afin que, dans le cas d'un défaut, une voie de remplacement pour le transfert des données soit toujours disponible, et dans lesquelles sont prévus des dispositifs de commutation servant à réaliser une commutation entre les voies doublées de transmission de données, avec utilisation d'une trame de cadence appliquée aux mémoires de compensation et uniforme du point de vue phase et fréquence et qui est régénérée sur la base de la cadence arrivante, qui est déformée par un temps de propagation et des tolérances sur les composants, dans un dispositif central.

8. Montage suivant la revendication 7, caractérisé par le fait que le signal de cadence régénéré est appliqué non seulement aux mémoires de compensation, mais est retransmis également à un dispositif de synchronisation qui est branché en amont des mémoires de compensation et à l'aide duquel des signaux arrivant d'un champ de couplage sont amenés à coïncider dans le temps avec le signal de cadence régénéré.

9. Montage suivant la revendication 7, caractérisé par le fait que dans le cas de l'utilisation d'une trame de cadence uniforme régénérée en phase et en fréquence, le canal de transmission d'informations, prévu pour la transmission de l'information de signalisation, est passant en direction d'un réseau de couplage de l'installation, indépendamment de la voie choisie de transmission de données.
